(19) Europäisches Patentamt
European Patent Office
Office européen des brevets

(11) **EP 2 230 714 A1**

(12) **EUROPEAN PATENT APPLICATION**

(43) Date of publication:
**22.09.2010 Bulletin 2010/38**

(51) Int Cl.:
**H01P 1/203** (2006.01)     **H03H 7/01** (2006.01)

(21) Application number: **10154547.3**

(22) Date of filing: **24.02.2010**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(30) Priority: **19.03.2009 JP 2009067170**

(71) Applicant: **FUJITSU LIMITED**
**Kawasaki-shi,**
**Kanagawa 211-8588 (JP)**

(72) Inventors:
• **Mi, Xiaoyu**
**Kawasaki-shi**
**Kanagawa 211-8588 (JP)**

• **Toyoda, Osamu**
**Kawasaki-shi,**
**Kanagawa 211-8588 (JP)**
• **Ueda, Satoshi**
**Kawasaki-shi,**
**Kanagawa 211-8588 (JP)**

(74) Representative: **Stebbing, Timothy Charles**
**Haseltine Lake LLP**
**5th Floor, Lincoln House**
**300 High Holborn**
**London, Greater London WC1V 7JH (GB)**

(54) **Filter, filtering method, and communication device**

(57)     A filter (1) includes a first resonance line (12a) and a second resonance line (12b) which extend from an input point (11) where a high frequency signal is input, wherein an electrical propagation length $L_1$ of the first resonance line (12a) is set at $L_1 = [\lambda_1/4] \times n$ and an electrical propagation length $L_2$ of the second resonance line (12b) is set at $L_2 = [\lambda_2/4] \times n$, wherein $\lambda_1$ and $\lambda_2$ are wavelengths of specified high frequency signals and n is a positive odd number.

F I G. 1

EP 2 230 714 A1

## Description

The present invention is related to a distributed constant type filter for use in bandwidth passage of high frequency signals, a communication device using the above, and a filtering method.

Recently, with the market expansion of a mobile communications such as cellular telephony, services increasingly demand high performance. Accordingly, frequency bands for use in the mobile communications are gradually shifting into the gigahertz (GHz) range and adopting multi-channels. Further, the possibility of introducing a Software-Defined-Radio (SDR) technology in the future is often discussed.

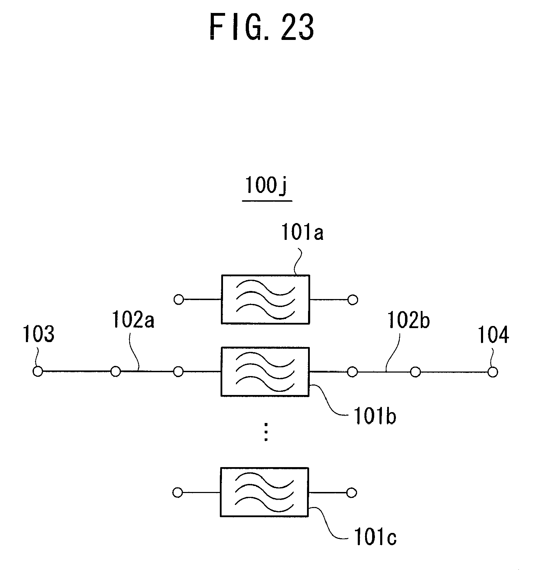

Fig. 23 is a circuit diagram illustrating the conventional frequency variable filter 100j.

In Fig. 23, the frequency variable filter 100j includes a plurality of channel filters 101a, 101b, 101c, ..., and switches 102a and 102b. By changing the switches 102a and 102b, one of the channel filters 101a, 101b, 101c, ..., is selected to switch the frequency band. The high frequency signals input from an input terminal 103 are subject to the filtering according to the selected channel filter 101 and supplied from an output terminal 104. The conventional frequency variable filter 100j, however, needs a number of channel filters equal to the number of channels, which makes the structure complicated, disadvantageous in size and cost. Further, this structure will reach a limit soon, unlike software-defined-radio technology.

Instead of the conventional frequency variable filter as mentioned above, a compact frequency variable filter using MEMS technology is drawing the attention these days. The MEMS device (micro machine device) using MEMS (Micro Electro Mechanical Systems) technology can obtain a high Q (quality factor) and it can be applied to a variable filter of high frequency band.

(D1) JP-A-2008-278147, (D2) D. Peroulis et al, "Tunable Lumped Components with Applications to Reconfigurable MEMS Filters", 2001 IEEE MTT-S Digest, p341-344, (D3) E. Foum et al, "MEMS Switchable Interdigital Coplanar Filter", IEEE Trans. Microwave Theory Tech., vol. 51, NO.1 p320-324, January 2003, and (D4) A. A. Tamijani et al, "Miniature and Tunable Filters Using MEMS Capacitors ", IEEE Trans. Microwave Theory Tech., vol. 51, NO. 7, p1878-1885, July 2003 disclose this kind of MEMS device. Since the MEMS device is compact and exhibits a small loss capability, it is often used for a CPW (Coplanar Waveguide) distributed constant resonator.

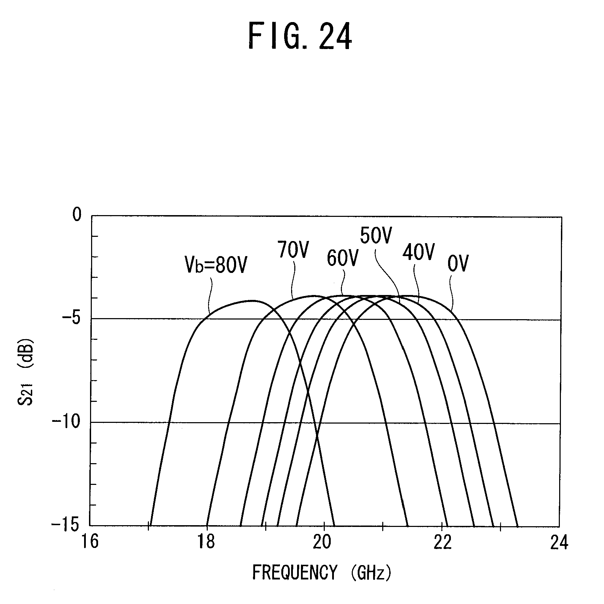

(D4) A. A. Tamijani et al, "Miniature and Tunable Filters Using MEMS Capacitors", IEEE Trans. Microwave Theory Tech., vol. 51, NO. 7, p1878-1885, July 2003, discloses a filter formed in that a plurality of variable capacitors made of MEMS devices step over three stepped distributed transmission lines. In this filter, a control voltage Vb is applied to a driving electrode of the MEMS device to displace the variable capacitor, to change a gap between the distributed transmission lines, and to change the capacitance. According to a change of the capacitance, the pass band of the filter varies. Relations between the control voltage Vb and the pass band are illustrated in Fig.24. Fig. 24 illustrates that the pass band of the filter varies in the range of about 21.5 - 18.5 GHz by changing the control voltage Vb in the range of 0 - 80 V.

The conventional filter as mentioned above, however, can change the central frequency of the pass band by using the MEMS device but it cannot change the pass bandwidth. For example, in the example illustrated in Fig. 24, the central frequency of the pass band varies about 3 GHz by changing the control voltage Vb but the pass bandwidth does not vary.

According to an embodiment of an invention, a filter includes a first resonance line and a second resonance line which extend from an input point where a high frequency signal is input, wherein an electrical propagation length $L_1$ of the first resonance line is set at $L_1 = [\lambda_1/4] \times n$ and an electrical propagation length $L_2$ of the second resonance line is set at $L_2 = [\lambda_2/4] \times n$, wherein $\lambda_1$ and $\lambda_2$ are wavelengths of specified high frequency signals and n is positive odd number.

An embodiment may provide a filter which may change a pass bandwidth, as well as a module and/or device comprising such a filter.

Reference is made, by way of example only, to the accompanying drawings in which:

Fig. 1 is a view illustrating the structure of a filter according to a first embodiment.

Figs. 2A and 2B are views each for use in describing an equivalent circuit in a resonance line.

Fig. 3 is a view illustrating an example of pass band characteristic of the filter.

Fig. 4 is a view illustrating another example of pass band characteristic of the filter.

Figs. 5A to 5C are views each illustrating a variation example of a resonance line pair.

Fig. 6 is a view illustrating the structure of a filter according to a second embodiment.

Fig. 7 is a view for use in describing the structure of another filter according to a third embodiment.

Figs. 8A to 8C are views each illustrating an example of a coupling circuit.

Figs. 9A to 9C are views each illustrating an example of the coupling circuit.

Figs. 10A to 10C are views each illustrating an example of the coupling circuit.

Figs. 11A to 11C are views each illustrating an example of the coupling circuit.

Figs. 12A and 12B are views each illustrating an example of the coupling circuit.

Fig. 13 is a view illustrating the structure of a filter according to a fourth embodiment.

Figs. 14A to 14C are views each illustrating a variation example of a resonance line pair.

Fig. 15 is a view for use in describing the structure of a filter according to a fifth embodiment.

Fig. 16 is a view illustrating an example of the structure of a variable capacitor.

Fig. 17 is a cross-sectional view of the variable capacitor illustrated in Fig. 16.

Figs. 18A to 18C are views for use in describing an example of the manufacturing process of a filter.

Figs. 19A and 19B are views for use in describing the example of the manufacturing process of the filter.

Figs. 20A and 20B are views for use in describing the example of the manufacturing process of the filter.

Fig. 21 is a view illustrating an example of the structure of a communication module.

Fig. 22 is a view illustrating an example of the structure of a communication device.

Fig. 23 is a circuit diagram illustrating the conventional frequency variable filter.

Fig. 24 is a view illustrating relations between the control voltage and the pass band in the conventional frequency variable filter.

Taking the above situation into consideration, an aspect of the embodiment aims to provide a filter, a filtering method, and a communication device capable of adjusting the pass bandwidth as well as the central frequency of the pass band.

According to an aspect of the embodiment, the pass bandwidth as well as the central frequency of the pass band can be adjusted.

[First Embodiment]

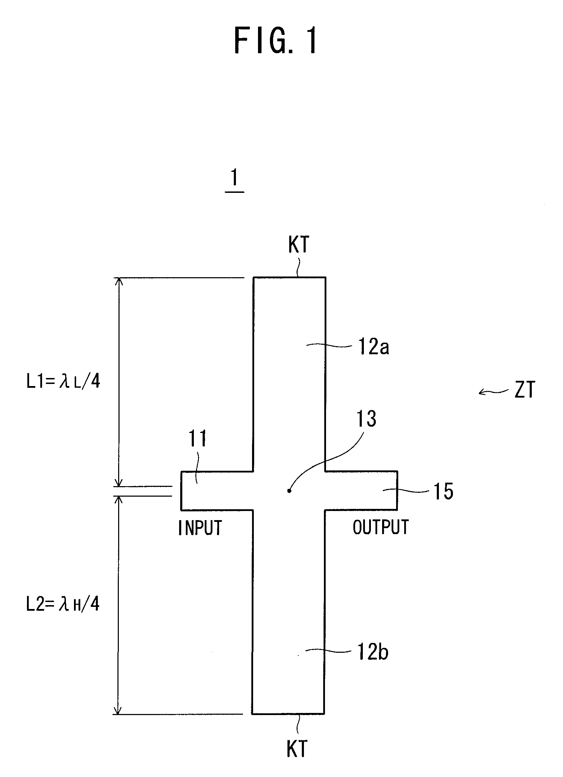

In Fig. 1, a filter 1 includes an input terminal 11, a first resonance line 12a, a second resonance line 12b, and an output terminal 15.

A high frequency signal S 1 is applied to the input terminal 11, filtered by the first resonance line 12a and the second resonance line 12b, and supplied from the output terminal 15 as a high frequency signal S2.

Each of the first resonance line 12a and the second resonance line 12b, works as a band pass filter which gives attenuation characteristics and pass characteristics to a region (frequency band) centred on a specified wavelength λ, determined according to a transmission length L thereof.

Namely, the high frequency signal S 1 applied to the input terminal 11 appears an input point 13, passing through a signal line or without passing through a signal line, for the first resonance line 12a and the second resonance line 12b. The first resonance line 12a and the second resonance line 12b extend straightly from the input point 13 in opposite directions, into a straight line. The end portions at the both opposite sides of the input point 13 respectively in the first resonance line 12a and the second resonance line 12b are formed in open ends KTs which are electrically open. The first resonance line 12a and the second resonance line 12b form a resonance line pair ZT.

An electrical propagation length $L_1$ of the first resonance line 12a and an electrical propagation length $L_2$ of the second resonance line 12b are expressed as the following formula (1):

$$L_1 = [\lambda_1/4] \times n,$$

$$L_2 = [\lambda_2/4] \times n \dots(1)$$

Where, $\lambda_1$ and $\lambda_2$ are wavelengths of specified high frequency signals and n is the positive odd number.

In this embodiment, n = 1. Therefore, the electrical propagation lengths $L_1$ and $L_2$ are 1/4 of the respective wavelengths $\lambda_1$ and $\lambda_2$. Namely, the first resonance line 12a and the second resonance line 12b resonate respectively with the high frequency signals of the wavelengths $\lambda_1$ and $\lambda_2$.

In the embodiment, the wavelengths $\lambda_1$ and $\lambda_2$ are the wavelengths giving the attenuation characteristic. Two wavelengths $\lambda_1$ and $\lambda_2$ have relations as the following formula (2).

$$\lambda_1 > \lambda_2 \dots(2)$$

Namely, the wavelength $\lambda_1$ is longer than the wavelength $\lambda_2$. Namely, a frequency $f_1$ corresponding to the wavelength $\lambda_1$ is lower than a frequency $f_2$ corresponding to the wavelength $\lambda_2$. Therefore, the wavelengths $\lambda_1$ and $\lambda_2$ and the frequencies $f_1$ and $f_2$ may be represented as $\lambda_L$, $\lambda_H$, $f_L$, and $f_H$ respectively.

The first resonance line 12a and the second resonance line 12b resonate with the high frequency signals of the wavelengths $\lambda_L$ ($\lambda_1$) and $\lambda_H$ ($\lambda_2$) as the resonance lines of 1/4 wavelength. This means that the first resonance line 12a and the second resonance line 12b work respectively for the high frequency signals of the wavelengths $\lambda_L$ and $\lambda_H$ as a series resonator (series resonant circuit) with each one end grounded.

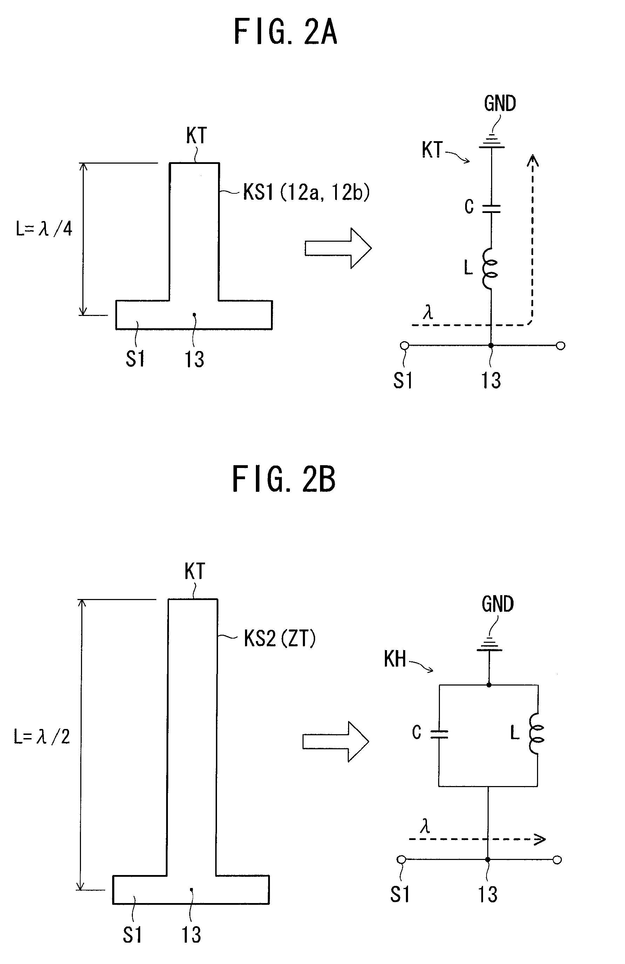

Namely, as illustrated in Fig. 2A, a resonance line KS 1 having the electrical propagation length L of $\lambda/4$ and one open end is equal to an LC series resonator KT with one end grounded. Therefore, series resonance occurs in the resonance line KS 1 in answer to the high frequency signal S 1 of the wavelength λ entered into the input point 13 that is one end of the resonance line KS1, which induces the high frequency signal S 1 to flow to a ground potential GND.

The ideal LC series resonator KT is to pass a high frequency signal of the resonance wavelength λ without loss. Therefore, the high frequency signal S1 of the wavelength λ is grounded with almost zero impedance by the LC series resonator KT; in other words, the resonance line KS 1 works on the high frequency signal S 1 of the wavelength $\lambda$ as an attenuator.

In the filter 1 illustrated in Fig. 1, the first resonance line 12a and the second resonance line 12b work on the high frequency signals of the respective wavelengths $\lambda_L$ and $\lambda_H$ as the band attenuators. According to this, attenuation peaks appear in the two wavelengths $\lambda_L$ and $\lambda_H$ with respect to the input high frequency signal S1.

The first resonance line 12a and the second resonance line 12b are symmetrically connected to the input point 13. When the two resonance lines each having the electrical propagation length L of $\lambda/4$ and one open end are connected to the input point 13, a total of the electrical propagation length L becomes $\lambda/2$. In this case, as illustrated in Fig. 2B, a resonance line KS2 having the electrical propagation length L of $\lambda/2$ and one open end is equivalent to an LC parallel resonator KH with one end grounded.

Therefore, the high frequency signal S1 of the wavelength $\lambda$ is kept at high impedance by the LC parallel resonator KH and it will be supplied from the input terminal 11 to the output terminal 15 as it is. In other words, the resonance line KS2 works on the high frequency signal S 1 of the wavelength $\lambda$ as a band pass unit.

In the filter 1 illustrated in Fig. 1, since the electrical propagation length $L_1$ of the first resonance line 12a is $\lambda_L/4$ and the electrical propagation length $L_2$ of the second resonance line 12b is $\lambda_H/4$, a total electrical propagation length $L_0$ becomes

$$L_0 = [(\lambda_L + \lambda_H)/2]/2 \ldots (3).$$

In short, the filter 1 works on the high frequency signal S 1 of wavelength $\lambda_0 = [(\lambda_L + \lambda_H)/2]$ as the band pass unit.

In summary, the filter 1 forms such a band pass filter, with the intermediate wavelength $\lambda_0 = [(\lambda_L + \lambda_H)/2]$ between the wavelength $\lambda_L$ and the wavelength $\lambda_H$ as a central pass wavelength, the wavelength $\lambda_L$ and the wavelength $\lambda_H$ at the both sides of the central pass wavelength $\lambda_0$ are attenuated.

When the absolute value of a difference between each of the wavelengths $\lambda_L$ and $\lambda_H$ and the central pass wavelength $\lambda_0$ is defined as $\Delta\lambda$, the electrical propagation lengths $L_1$ and $L_2$ of the first resonance line 12a and the second resonance line 12b can be represented as the following formula (4):

$$L_1 = [(\lambda_0 + \Delta\lambda)/4] \times n$$

$$L_2 = [(\lambda_0 - \Delta\lambda)/4] \times n \ldots (4)$$

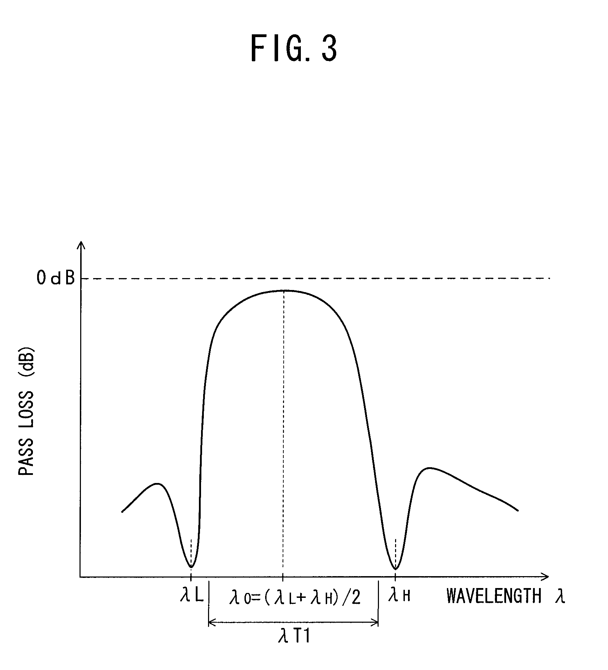

In Fig. 3, the pass loss characteristic (frequency characteristic) of the filter 1 exhibits no loss in the central pass wavelength $\lambda_0$ and large loss in the wavelength $\lambda_L$ and wavelength $\lambda_H$. The filter 1 becomes a band pass filter having a sharp waveform characteristic by positively giving the filter 1 the attenuation characteristic in the two wavelengths $\lambda_L$ and $\lambda_H$. Here, it is not restricted that the peak of the passing amount always occurs in the central pass wavelength $\lambda_0$.

Further, by making variably adjustable the two wavelengths $\lambda_L$ and $\lambda_H$, namely the two electrical propagation lengths $L_1$ and $L_2$, attenuation wavelength can be changed and a pass bandwidth $\lambda T1$ of the filter 1 can be changed. The sharpness of the pass bandwidth $\lambda T1$ can be adjusted according to the values of the two wavelengths $\lambda_L$ and $\lambda_H$.

When the resonance line is within the insulating material having a relative dielectric constant $\varepsilon r$, the electrical propagation length L of the resonance line is defined by the electrical propagation length L = La $\times \varepsilon e^{1/2}$, as for a physical actual length La of the resonance line. Namely, with respect to the high frequency signal of the wavelength $\lambda$, the physical length La of the resonance line for one wavelength becomes La = $\lambda/\varepsilon e^{1/2}$, shortened into $1/\varepsilon e^{1/2}$.

Here, the $\varepsilon e$ means an effective dielectric constant of a distributed transmission line. The effective dielectric constant $\varepsilon e$ is in proportion to the relative dielectric constant $\varepsilon r$ and it is related to the structure of the distributed transmission line. For example, in the case of microstrip-line configuration, the effective dielectric constant $\varepsilon e$ depends on the relative dielectric constant $\varepsilon r$ and a thickness h of the insulating material and a width W and a thickness t of the line.

For example, in the air, each of the relative dielectric constant $\varepsilon r$ and the effective dielectric constant $\varepsilon e$ (= 1.007) is almost one and the electrical propagation length L is almost equal to the physical length La of the resonance line. When a low temperature co-fired ceramic substrate (LTCC: Low temperature Co-fired Ceramics) is used as a substrate, when the relative dielectric constant $\varepsilon r$ is defined as seven, the effective dielectric constant $\varepsilon e$ becomes about 4.9 (when h = 0.2 mm, t = 6 $\mu$m, W = 260 $\mu$m, and impedance = 50 $\Omega$) and the electrical propagation length L becomes about 2.21 times longer than the physical length La. In this case, the physical length La of the resonance line may be (1/2.21) of the wavelength $\lambda$ of the high frequency signal.

Taking a concrete example, the physical length La of the resonance line of $\lambda/4$ is required with respect to the high frequency signal of 2 GHz in the following way. Since the wavelength $\lambda$ of the 2 GHz high frequency signal is 150 mm, it becomes 37.5 mm in the $\lambda/4$. In the substrate having the relative dielectric constant $\varepsilon r$ of sev-

en, since the physical length La of the resonance line may be (1/2.21) of the above, La = 16.9 mm.

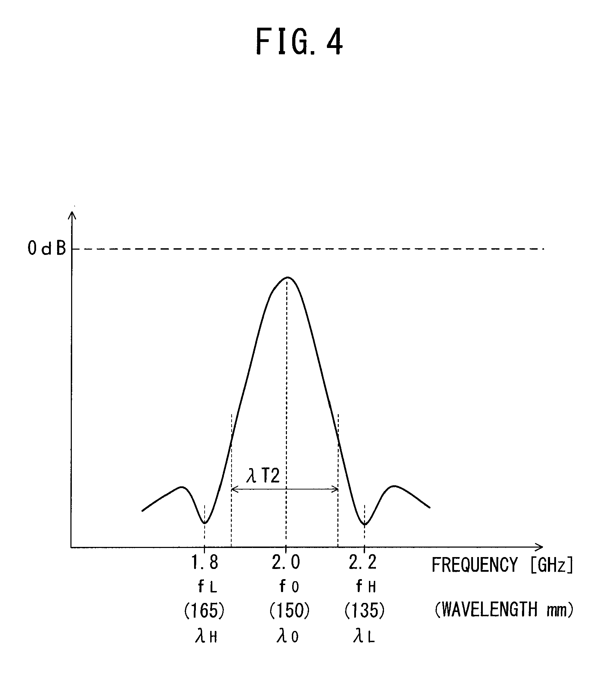

For example, when the central pass frequency $f_0$ is defined as 2 GHz and the attenuation frequencies $f_L$ and $f_H$ are defined as 1.8 GHz and 2.2 GHz, the wavelengths $\lambda_L$ and $\lambda_H$ of the attenuation frequencies $f_L$ and $f_H$ become 165 mm and 135 mm respectively, and the $\lambda_L/4$ and $\lambda_H/4$ become 33.8 mm and 41.3 mm respectively. In the substrate having the relative dielectric constant $\varepsilon r$ of seven as mentioned above, the respective physical lengths La of the resonance lines become 15.4 mm and 18.8 mm. The pass loss characteristic expected as for this filter is illustrated in Fig. 4. In Fig. 4, the central pass frequency $f_0$ takes 2 GHz and the attenuation frequencies $f_L$ and $f_H$ take 1.8 GHz and 2.2 GHz respectively. A pass bandwidth capable of passing within a predetermined loss rate is illustrated as $\lambda T2$.

Here, the central pass frequency $f_0$ and the attenuation frequencies $f_L$ and $f_H$ can be selected from various values. When the attenuation frequencies $f_L$ and $f_H$ approach each other, the pass bandwidth $\lambda T$ gets narrow; however, the loss in the central pass frequency $f_0$ is supposed to get larger. These values may be determined taking various conditions into consideration.

Further, when a band pass filter having a further sharper waveform characteristic is required, a plurality of resonance line pairs are sequentially connected by proper coupling units into a connection of several steps, as will be mentioned later. As the coupling unit, $\pi$-type coupling and T-type coupling can be used.

In Fig. 1, the electrical propagation lengths $L_1$ and $L_2$ are respectively based on the lengths from the vicinity of the input point 13 to the respective open ends KT of the first resonance line 12a and the second resonance line 12b, but the range covered by the physical length La varies depending on the shapes of the first resonance line 12a, the second resonance line 12b, the input terminal 11, and the output terminal 15, and the structure of their vicinity and the materials.

In order to accurately set the electrical propagation lengths $L_1$ and $L_2$ of the first resonance line 12a and the second resonance line 12b, namely the central pass frequency $f_0$ and the attenuation frequencies $f_L$ and $f_H$, a variable capacity element or elements are provided in one or the both of the first resonance line 12a and the second resonance line 12b, to adjust the electrical propagation lengths $L_1$ and $L_2$, as will be described later.

For example, using the MEMS technology, one or a plurality of movable capacitor electrodes and a driving electrode for displacing the movable capacitor electrode or electrodes are provided in each of the first resonance line 12a and the second resonance line 12b, in order to apply a control voltage Vb to the driving electrode to displace the variable capacitor electrode.

As the variable capacity element, a lumped constant circuit element such as a variable capacitor and a varactor can be used.

The first resonance line 12a, the second resonance line 12b, the input terminal 11, and the output terminal 15 as mentioned above can be realized by forming a low resistant metal thin film on a low temperature co-fired ceramic substrate having multi-layered internal wiring, or a wafer having such a low temperature co-fired ceramic substrate, or the other proper substrate. The first resonance line 12a, the second resonance line 12b, the movable capacitor electrode, and the driving electrode can be formed on the common substrate. Here, the ground layer and the wiring may be formed within the substrate. The passive parts including the signal line, the inductor, and the capacitor may be formed on the substrate.

When a print substrate or a pad for connecting to the other external unit is formed on the back surface of the substrate, surface mounting is possible.

[Variation Example]

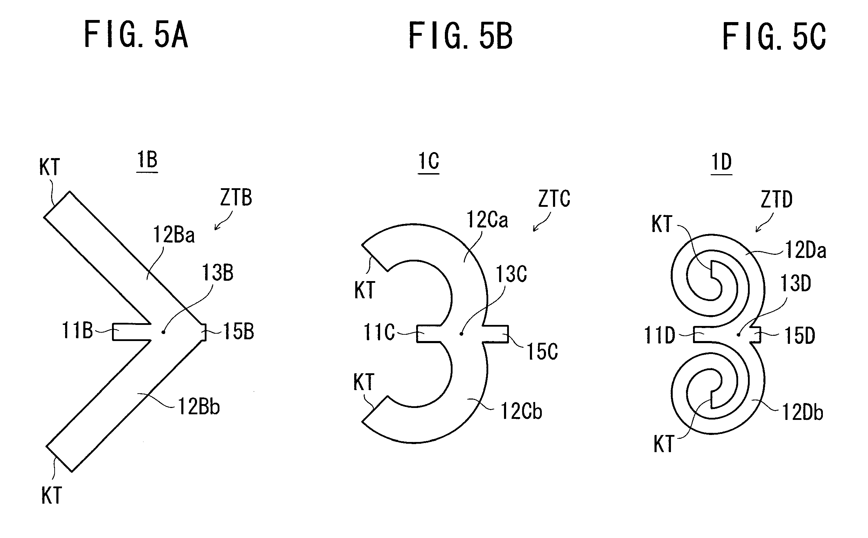

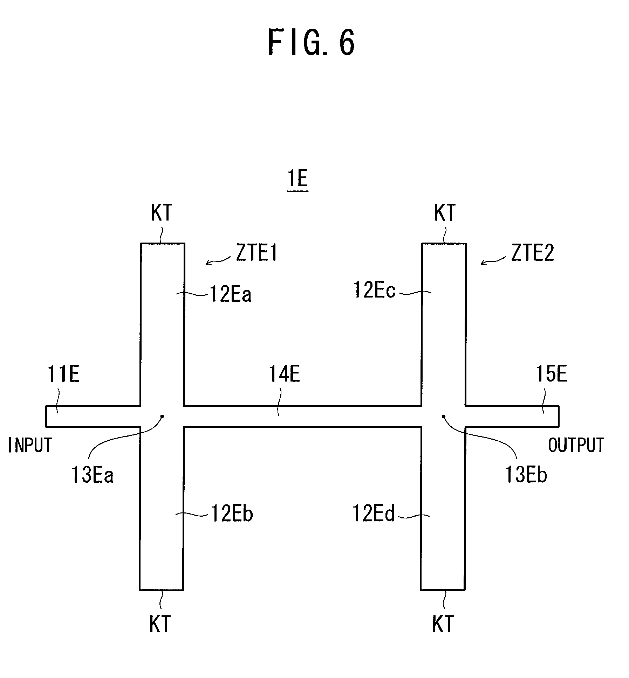

In the filter 1 according to the above mentioned embodiment, the resonance line pair ZT is arranged into a shape of straight line. Next, variation examples of the shape and the arrangement of the resonance line pair ZT are illustrated in Figs. 5A to 5C. In filters 1B, 1C, and 1D of the variation examples illustrated in Fig. 5A to 5C, the elements having the same functions as the respective elements of the above mentioned filter 1 are illustrated with the codes B, C, and D attached. It is the same in Figs. 6 and later.

In the filter 1B illustrated in Fig. 5A, a first resonance line 12 Ba and a second resonance line 12Bb are formed respectively in linear shapes; however, they are not formed totally into a straight line but arranged at an angle. By arranging the first resonance line 12 Ba and the second resonance line 12Bb at an angle, the size in a longitudinal direction in Fig. 5A can be shortened.

In the filter 1C illustrated in Fig. 5B, a first resonance line 12Ca and a second resonance line 12Cb are formed respectively in arc shapes. By forming them in arc shapes, the size in a longitudinal direction in Fig. 5B can be shortened further.

In the filter 1D illustrated in Fig. 5C, a first resonance line 12Da and a second resonance line 12Db are formed respectively in spiral shapes. By forming them in spiral shapes, the size in a longitudinal direction in Fig. 5C can be shortened further. Besides, they may be formed in, for example, meandering shapes.

In the filter 1 according to the first embodiment, there is a possibility of changing the pass loss characteristic, due to the output impedance in a stage before feeding the high frequency signal S 1 to the input terminal 11 and the input impedance in a stage after connecting to the output terminal 15, and in order to make up for this, a line or a circuit having a proper impedance may be provided before and after the input point 13.

[Second Embodiment]

In a filter 1E according to a second embodiment, a plurality of resonance line pairs ZTE1 and ZTE2 are sequentially connected by a coupling unit 14E. The description having been made in the first embodiment can be applied to the resonance line pairs ZTE1 and ZTE2 and the other components and its detailed description is omitted here. It is the same also in a third embodiment and later.

In Fig. 6, the filter 1E includes an input terminal 11E, the resonance line pair ZTE1 formed by a first resonance line 12Ea and a second resonance line 12Eb, the resonance line pair ZTE2 formed by a first resonance line 12Ec and a second resonance line 12Ed, the coupling unit 14E, and an output terminal 15E.

The first resonance line 12Ea, the second resonance line 12Eb, the first resonance line 12Ec, and the second resonance line 12Ed have electrical propagation lengths $L_1$, $L_2$, $L_3$, and $L_4$ respectively. When the electrical propagation length $L_1$ of the first resonance line 12Ea is equal to the electrical propagation length $L_3$ of the first resonance line 12Ec and the electrical propagation length $L_2$ of the second resonance line 12Eb is equal to the electrical propagation length $L_4$ of the second resonance line 12Ed, the two resonance line pairs ZTE1 and ZTE2 have the same pass loss characteristic. Alternatively, it is also possible to make the above electrical propagation lengths various, to provide the two resonance line pairs ZTE1 and ZTE2 with different pass loss characteristics, hence to obtain a desired pass loss characteristic when they are combined.

The coupling unit 14E serves to rotate the phase of the high frequency signal resonating in the resonance line pair ZTE1 by 90 degree ($\lambda$/4) and to transmit it to the next resonance line pair ZTE2 without reflection. In other words, it serves to transmit a high frequency signal in an input point 13Ea to a next input point 13Eb with selectivity of a specified frequency component.

The coupling unit 14E illustrated in Fig. 6 is a resonance line with an electrical propagation length $L_{14}$ of $\lambda_{14}/4$. Here, the wavelength $\lambda_{14}$ may be equal to the electrical propagation length $L_0$ that is a total of the first resonance line 12Ea and the second resonance line 12Eb, or it may be equal to the electrical propagation length $L_0$ that is a total of the first resonance line 12Ec and the second resonance line 12Ed, or it may be the electrical propagation length $L_0$ that is intermediate of them. In other words, the coupling unit 14E may be a resonance line having the electrical propagation length $L_{14}$ of $\lambda_0/4$ with respect to the central pass wavelength $\lambda_0$ in the filter 1 E. According to this, it is possible to transmit the high frequency signal of the central pass wavelength $\lambda_0$ without loss and to enhance the sharpness of the pass loss characteristic.

Further, a $\pi$-type coupling unit and a T-type coupling unit as described later, and the other coupling unit can be used as the coupling unit 14E.

Since the filter 1E is formed in a two-stepped structure using the two resonance line pairs ZTE1 and ZTE2, it can get a sharper pass loss characteristic than in a one step case illustrated in Fig. 1.

The resonance line pair ZT can be formed in a multi-stepped structure more than two. For example, it can be formed in a three-stepped structure, a four-stepped structure, a five-stepped structure or the more. By increasing the number of steps using the resonance line pair ZT and the coupling unit 14E, the number of the steps for the resonance lines or the resonators included in the whole filter increases, hence to realize a filter exhibiting further sharpness.

Various variation examples having been described in the first embodiment can be applied also to the filter 1E.

[Third Embodiment]

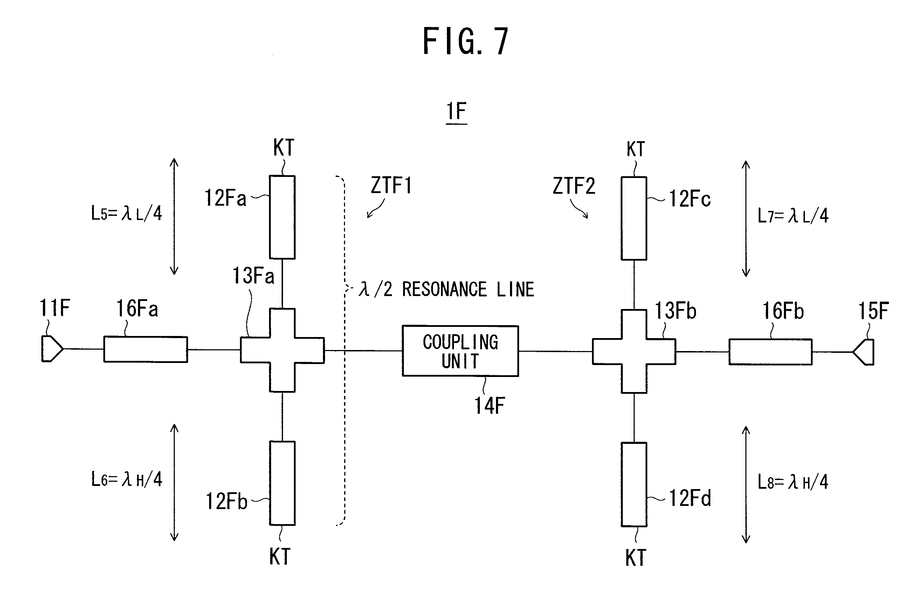

As illustrated in Fig. 7, in a filter 1F according to a third embodiment, a plurality of resonance line pairs ZTF1 and ZTF2 are sequentially connected by a coupling unit 14F. The filter 1F illustrated in Fig. 7, where each element is schematically arranged and illustrated, is functionally the same as the filter 1E illustrated in Fig. 6.

In Fig. 7, the filter 1F has an input terminal 11F, the resonance line pair ZTF1 including a first resonance line 12Fa and a second resonance line 12Fb, the resonance line pair ZTF2 including a first resonance line 12Fc and a second resonance line 12Fd, contacts 13Fa and 13Fb, the coupling unit 14F, an input signal line 16Fa, an output signal line 16Fb, and an output terminal 15F.

The first resonance line 12Fa, the second resonance line 12Fb, the first resonance line 12Fc, and the second resonance line 12Fd have electrical propagation lengths $L_5$, $L_6$, $L_7$, and $L_8$ respectively. Various values can be set in the electrical propagation lengths $L_5$, $L_6$, $L_7$, and $L_8$, as having been described in the first and the second embodiments.

The contacts 13Fa and 13Fb are the same as the input point 13 having been described in the first and the second embodiments. The input point 13, however, illustrates a geometric point having no area, while the contacts 13Fa and 13Fb illustrate portions actually having some area for connecting the resonance line pairs ZT.

The coupling unit 14F is the same as the coupling unit

14E in the second embodiment and it serves to transmit a high frequency signal in the contact 13Fa to the next contact 13Fb with selectivity of a specified frequency component. As the coupling unit 14F, one circuit block is used.

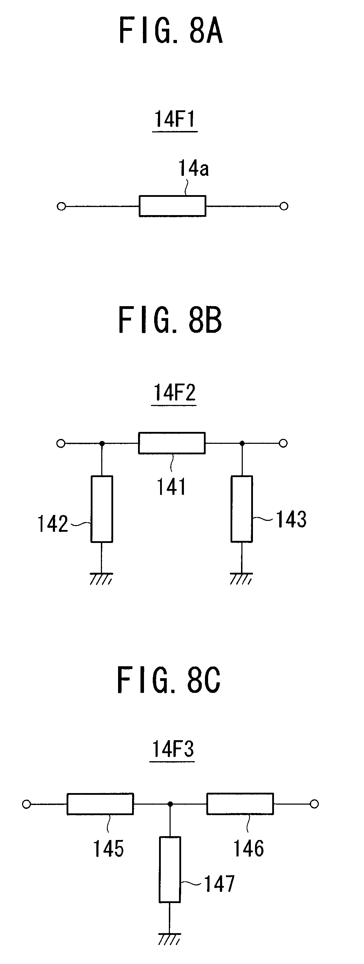

Next, a circuit example of the coupling unit 14F will be described with reference to Figs. 8A to 12B.

A coupling unit 14F1 illustrated in Fig. 8A is one circuit block 14a for connecting the two contacts 13Fa and 13Fb. The circuit block 14a is a distributed constant circuit having a proper characteristic impedance. For example, the circuit block 14a may be a resonance line having the electrical propagation length of $\lambda/4$, as having been described in Fig. 6.

The characteristic impedance of the circuit block 14a is close to the characteristic impedance in the filter 1F and higher than the characteristic impedance of the resonance line pairs ZTF1 and ZTF2. Here, the characteristic impedance of the filter 1F may be defined as 50 Ω and the characteristic impedance of each of the resonance line pairs ZTF1 and ZTF2 may be defined as about 20 Ω.

The characteristic impedance of the filter 1F can be adjusted, according to the structure of a substrate forming the filter 1F, the arrangement of each element and ground pattern in the substrate, especially the shape and arrangement of the input signal line 16Fa and the output signal line 16Fb.

Instead of the circuit block 14a, for example, a capacitor for coupling having a proper capacitance may be used.

A coupling unit 14F2 illustrated in Fig. 8B is an example of the π-type coupling circuit. Namely, three circuit blocks 141 to 143 are formed into π-shape. A coupling unit 14F3 illustrated in Fig. 8C is an example of the T-type coupling circuit. Namely, three circuit blocks 145 to 147 are formed into T-shape.

These circuit blocks 141 to 143, 145 to 147 are realized by distributed constant elements or lumped constant elements. As the distributed constant element, for example, a microstrip line is used. As the lumped constant element, a capacitor or an inductor is used. These circuit blocks 141 to 143, 145 to 147 may be formed of a single element as mentioned above or it may be formed by a combination circuit of these elements.

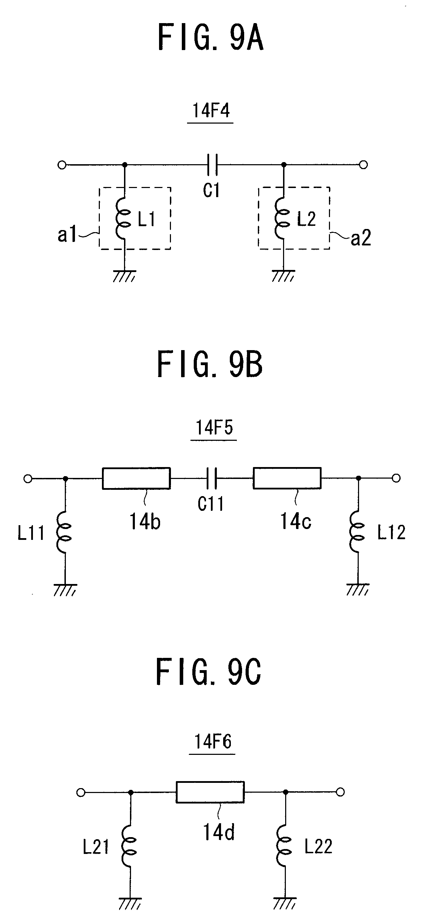

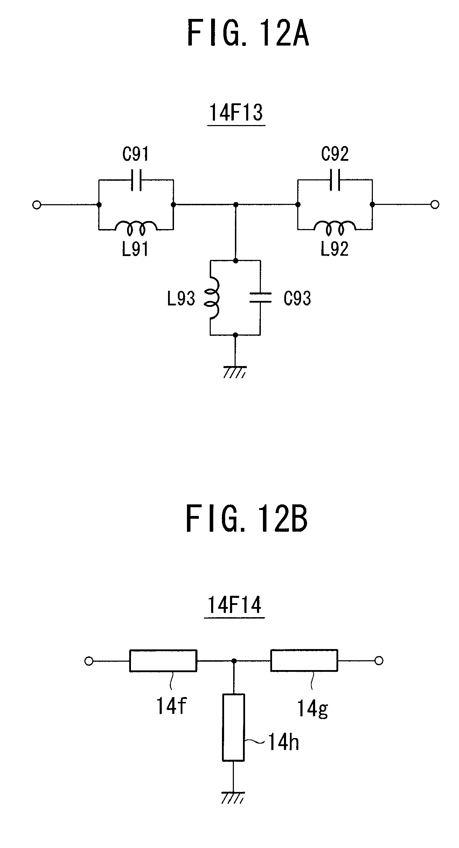

Figs. 9A to 11C illustrate each concrete example of the π-type coupling circuit, and Fig. 12A and 12B illustrate concrete examples of the T-type coupling circuit.

Namely, a coupling unit 14F4 illustrated in Fig. 9A includes one capacitor C1 for coupling and two inductors L1 and L2. A coupling unit 14F5 illustrated in Fig. 9B includes a capacitor C11 for coupling, with two circuit blocks 14b and 14c inserted there in series. A coupling unit 14F6 illustrated in Fig. 9C includes one circuit block 14d, instead of the capacitor C1 for coupling. The circuit blocks 14b, 14c, and 14d are the distributed constant circuits each having a proper characteristic impedance.

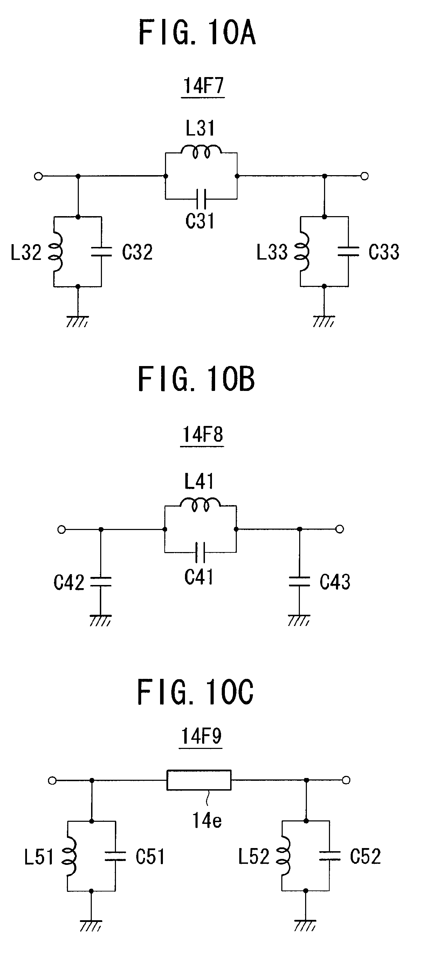

In a coupling unit 14F7 illustrated in Fig. 10A, a parallel circuit of a capacitor and an inductor is used for the respective circuit blocks 141 to 143. In a coupling unit 14F8 illustrated in Fig. 10B, each one of capacitors C42 and C43 is respectively used for each one of the circuit blocks 142 and 143. In a coupling unit 14F9 illustrated in Fig. 10C, one circuit block 14e is used for the circuit block 141.

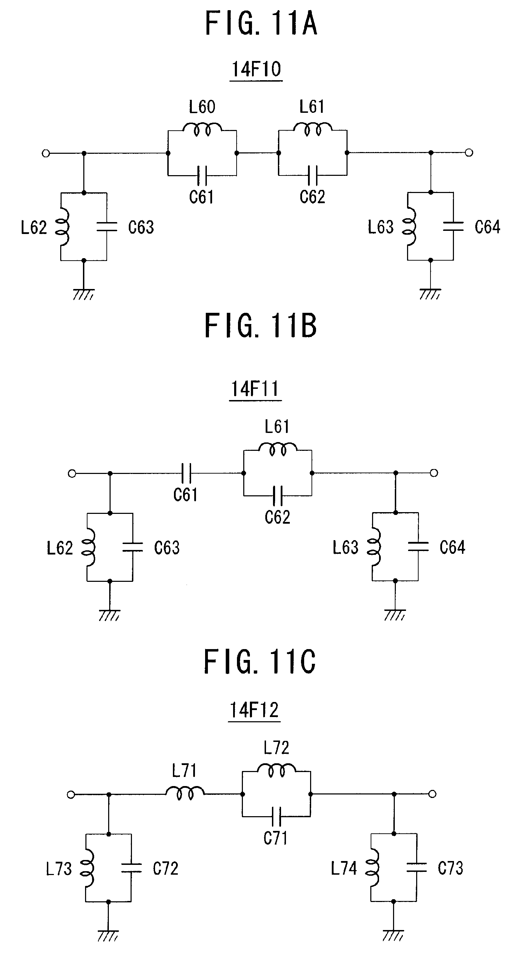

In a coupling unit 14F10 illustrated in Fig. 11A, two parallel circuits each formed of a capacitor and an inductor, connected in series, are used for the circuit block 141. In a coupling unit 14F11 illustrated in Fig. 11B, a parallel circuit of a capacitor C62 and an inductor L61 and one capacitor C61, which are connected in series, are used for the circuit block 141. In a coupling unit 14F12 illustrated in Fig. 11C, a parallel circuit of a capacitor C71 and an inductor L72 and one inductor L71, which are connected in series, are used for the circuit block 141.

In a coupling unit 14F13 illustrated in Fig. 12A, three parallel circuits each formed of a capacitor and an inductor are used. In a coupling unit 14F14 illustrated in Fig. 12B, three circuit blocks 14f, 14g, and 14h are used.

These coupling circuits illustrated in Figs. 8A to 12B can be applied also to the filters 1 and 1B in the first and the second embodiments. Various circuits other than the circuits illustrated in Figs. 8A to 12B may be used as the coupling unit.

[Fourth Embodiment]

In the filters according to the above mentioned first to third embodiments, the electrical propagation length L in each resonance line 12 and each coupling units 14 is fixed. On the contrary, the MEMS technology is used to form a variable capacitor, hence to enable the electrical propagation length L in each resonance line 12 and each coupling unit 14 variable. By making the electrical propagation length L variable, the central pass frequency $f_0$ and the attenuation frequencies $f_L$ and $f_H$ in the filter can be variable, hence to form a frequency variable filter.

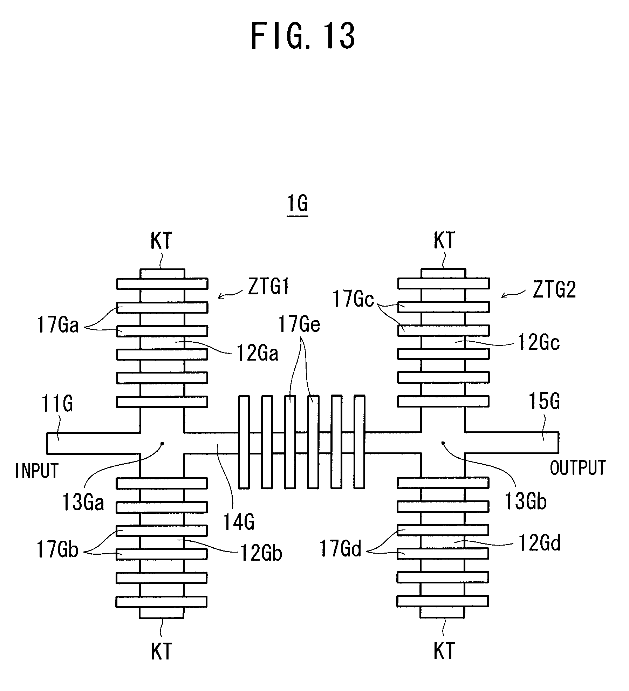

In a filter 1G illustrated in Fig. 13, variable capacitors 17Ga to Ge are added to the first resonance line 12Ea, the second resonance line 12Eb, the first resonance line 12Ec, the second resonance line 12Ed, and the coupling unit 14E in the filter 1E illustrated in Fig. 6.

Namely, in Fig. 13, the filter 1G has the variable capacitors 17Ga to Ge added to a first resonance line 12Ga, a second resonance line 12Gb, a first resonance line 12Gc, a second resonance line 12Gd, and a coupling unit 14G that is the resonance line.

Each of the variable capacitors 17Ga to Ge is formed of, for example, several electrodes which are arranged in a way of stepping over each of the resonance lines with a predetermined gap. These electrodes, namely the movable capacitor electrodes can be formed as the MEMS device as mentioned above, together with the electrodes (driving electrodes) for displacing the movable capacitor electrodes.

Here, when the capacitors are mounted on a distributed transmission line having some physical length in a way of stepping over the line, the electrical propagation length L of the distributed transmission line gets longer than in the case of mounting no capacitor. Therefore, the physical length La of the distributed transmission line necessary to obtain the specified electrical propagation length $L_1$, for example, the electrical propagation length $L_1$ corresponding to $\lambda_1/4$ on the specified wavelength $\lambda_1$, gets shorter because of the mounted capacitor. In forming a resonance line for the specified wavelength $\lambda_1$, the physical actual length of the resonance line gets shorter, into a compact size.

By displacing the capacitor stepping over the line, the gap between the line and the capacitor becomes variable.

In other words, the capacitor is formed by the movable capacitor electrode and the movable capacitor electrode is displaced. When the movable capacitor electrode comes close to the resonance line, capacitance increases and the electrical propagation length L gets longer. Namely, the wavelength $\lambda$ for resonating the resonance line gets longer. Thus, by adjusting the displacement of the movable capacitor electrode, the resonance wavelength of the resonance line becomes selectable.

By adjusting the respective capacitances of the variable capacitors 17Ga to Ge while operating them individually, the electrical propagation lengths $L_1$, $L_2$, $L_3$, $L_4$, and $L_{14}$ can be adjusted and freely set.

Therefore, in the filter 1G, through adjustment of the variable capacitors 17Ga to Ge, the central pass wavelength $\lambda_0$, the wavelengths $\lambda_L$ and $\lambda_H$ of the attenuation peak, and the pass bandwidth $\lambda T$ can be adjusted and set at various values.

In the filter 1G illustrated in Fig. 13, by way of example, each of the variable capacitors 17Ga to Ge has six movable capacitor electrodes as for one resonance line; however, it may have one to five or seven and more movable capacitor electrodes. Further, each area of each movable capacitor electrode may be various and each gap with the resonance line may be varied.

The concrete structural examples of the variable capacitors 17Ga to Ge will be described later.

[Variation Example]

In the above mentioned filter 1G according to the fourth embodiment, the resonance line pair ZT is formed into a straight line shape. On the contrary, as having been described in the variation example of the first embodiment, the resonance line pair ZT may be formed in various shapes or arrangements.

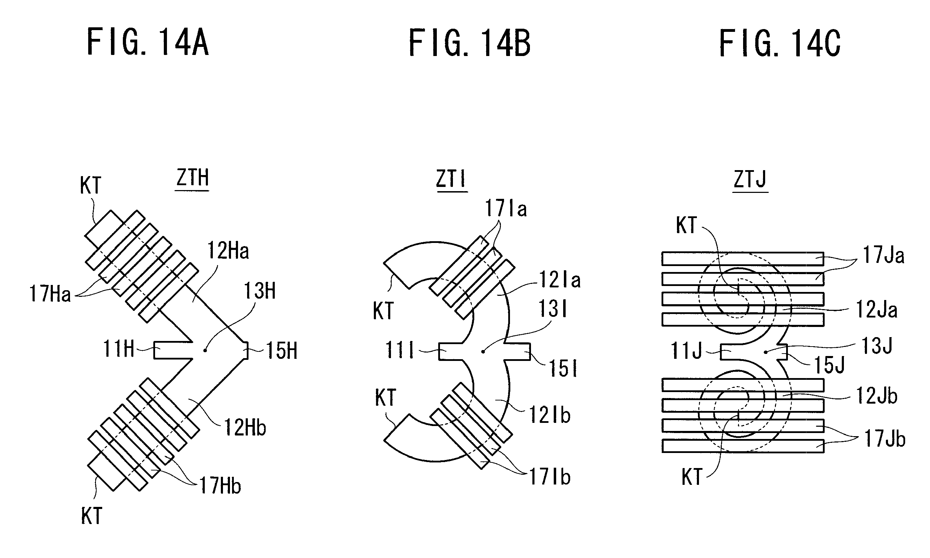

Figs. 14A to 14C illustrate variation examples of resonance line pairs ZTH, ZTI, and ZTJ. Since these resonance line pairs ZTH, ZTI, and ZTJ correspond to resonance line pairs ZTB, ZTC, and ZTD illustrated in Figs. 5A to 5C, the description here is omitted.

As illustrated in Figs. 14A to 14C, the respective resonance line pairs ZTH, ZTI, and ZTJ are provided with respective variable capacitors 17Ha and 17Hb, 17Ia and 17Ib, and 17Ja and 17Jb. By working the respective variable capacitors 17Ha and 17Hb, 17Ia and 17Ib, and 17Ja and 17Jb individually, the central pass wavelength $\lambda_0$, the wavelengths $\lambda_L$ and $\lambda_H$ of the attenuation peak, and the pass bandwidth $\lambda T$ in each of the resonance line pairs ZTH, ZTI, ZTJ can be adjusted.

[Fifth Embodiment]

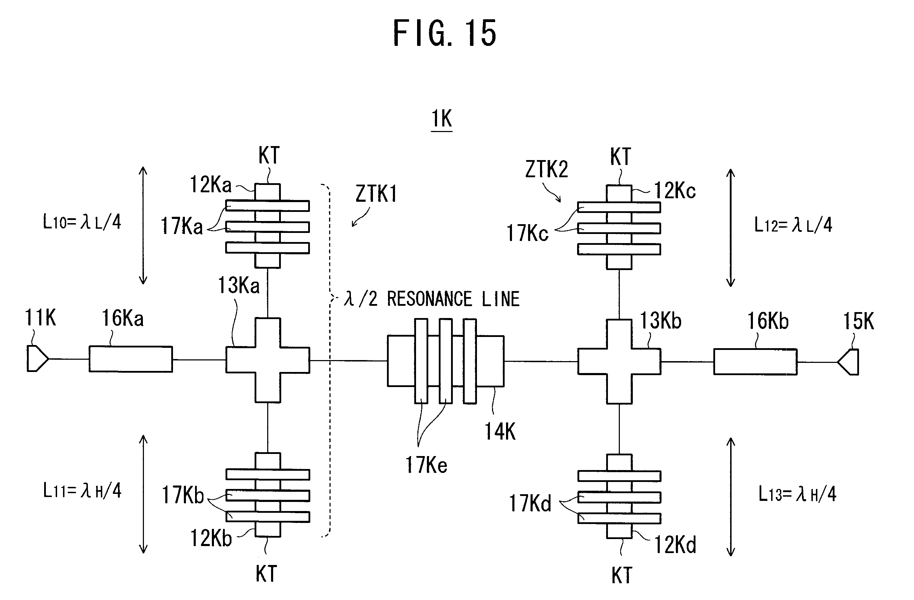

As illustrated in Fig. 15, in a filter 1K according to a fifth embodiment, a plurality of resonance line pairs ZTK1 and ZTK2 are sequentially connected by a coupling unit 14K. In the filter 1K illustrated in Fig. 15, each element is schematically arranged and illustrated similarly to the case of Fig. 7.

In Fig. 15, the filter 1K has an input terminal 11K, the resonance line pair ZTK1 including a first resonance line 12Ka and a second resonance line 12Kb, the resonance line pair ZTK2 including a first resonance line 12Kc and a second resonance line 12Kd, contacts 13Ka and 13Kb, the coupling unit 14K, an input signal line 16Ka, an output signal line 16Kb, variable capacitors 17Ka to Ke, and an output terminal 15K.

The first resonance line 12Ka, the second resonance line 12Kb, the first resonance line 12Kc, and the second resonance line 12Kd have respective electrical propagation lengths $L_{10}$, $L_{11}$, $L_{12}$, and $L_{13}$. These electrical propagation lengths $L_{10}$, $L_{11}$, $L_{12}$, and $L_{13}$ can be changed into various values by adjusting the variable capacitors 17Ka to Kd.

Also, the coupling unit 14K can be provided with various frequency characteristics by changing and adjusting the variable capacitor 17Ke. As this coupling unit 14K, a proper one can be selected from the above-mentioned various circuit blocks.

Accordingly, in the filter 1K, through adjustment of the variable capacitors 17Ka to Ke, the central pass wavelength $\lambda_0$, the wavelengths $\lambda_L$ and $\lambda_H$ at the attenuation peak, and the pass bandwidth $\lambda T$ can be adjusted and set at various values.

[Description of Structure of Variable Capacitor]

Next, an example of the structure of the variable capacitor 17Ga will be described.

As mentioned above, the whole filter including the variable capacitor 17Ga can be formed as the MEMS device.

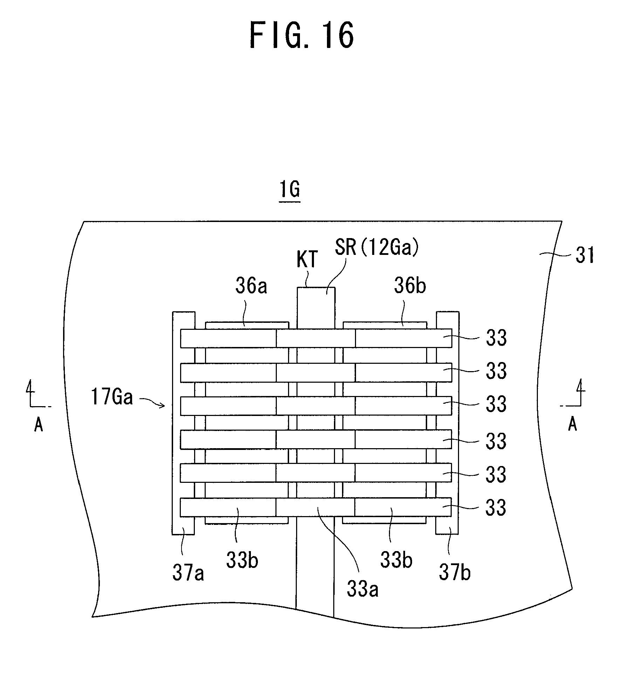

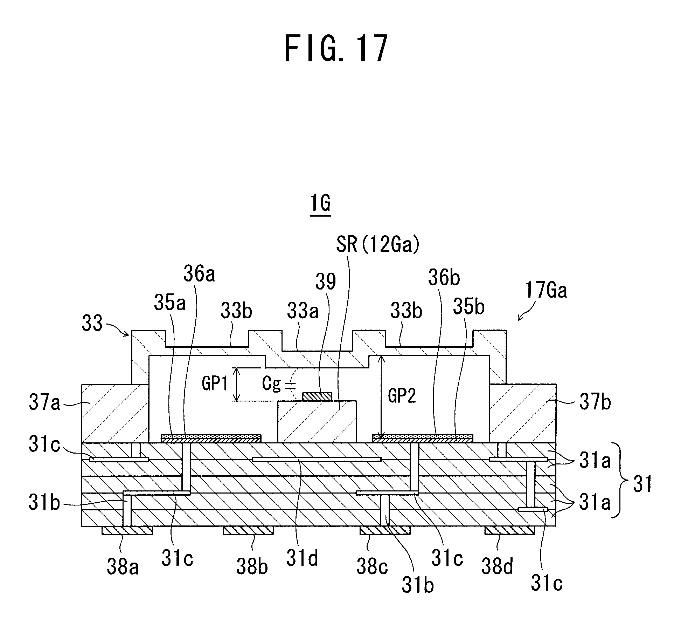

Fig. 16 is a plan view illustrating the variable capacitor 17Ga and a portion of the first resonance line 12Ga in the filter 1G of Fig. 13 in an enlarged way, and Fig. 17 is a cross sectional view taken along the line A-A in Fig. 16.

The structure described in Figs. 16 and 17 can be applied not only to the portion of the first resonance line 12Ga but also to the other resonance line or the other line, and therefore, in the following description, "line SR" will be used instead of the "first resonance line 12Ga".

In Figs. 16 and 17, the filter 1G is formed on a substrate 31 formed of LTCC wafer having multi-layered internal wiring.

The substrate 31 is formed by mutually bonding a plurality of insulating layers 31a, 31a, .... In the example illustrated in Fig. 17, the insulating layer 31a includes five layers. In the respective insulating layers 31a, through holes covering from one surface to the other surface are formed and each via 31b provided with a conductive portion is formed within the through hole. Further, wiring patterns 31c are formed at least in one interlayer of the insulating layers 31a, as internal wiring. One of the wiring patterns 31c which are formed in the interlayer closest to the upper surface of the substrate 31 is formed as a ground layer 31d connected to the ground.

The ground layer 31d is opposite to the line SR with a predetermined gap by interposing the uppermost insulating layer 31a. Here, the ground layer 31d may be formed in an interlayer lower than the uppermost interlayer. In this case, since the ground layer 31d is opposite to the line SR with the plurality of insulating layers 31a intervening therebetween, the interval between the ground layer 31d and the line SR gets larger accordingly.

Further, the vias 31b may connect the mutual wiring patterns 3 1 c, the wiring patterns 31c with pads 38a to 38d, and depending on the case, the wiring pattern 31c with the line SR, at each proper position. Here, the insulating layer 31 a can be realized by, for example, LTCC (Low Temperature Co-fired Ceramics). The LTCC material may include $SiO_2$ in some cases. The insulating layer 31a can be formed of the other dielectric material not only of the LTCC.

The upper surface of the substrate 31 is provided with the line SR, driving electrodes 35a and 35b, anchor units 37a and 37b, while the lower surface of the substrate 31 is provided with the pads 38a to 38d. The resonance line KS is formed of low resistance metal materials such as Cu, Ag, Au, Al, W, and Mo. The thickness of the resonance line KS is, for example, about 0.5 to 20 $\mu$m.

The driving electrodes 35a and 35b and the anchor units 37a and 37b are electrically connected to some of the pads 38a to 38d through the internal wiring of the substrate 31 and the vias 31b. Further, the top surfaces of the driving electrodes 35a and 35b are provided with dielectric films 36a and 36b respectively. There are some cases where these dielectric films 36a and 36b are not formed.

A variable electrode 33 is provided there being supported by the anchor units 37a and 37b. The variable electrode 33 is formed of elastic deformable low resistance metal such as Au, Cu, and Al. The variable electrode 33 is provided with a thick movable capacitor electrode 33a in its middle portion and thin spring electrodes 33b and 33b at its both sides.

These variable electrode 33, driving electrodes 35a and 35b, and anchor units 37a and 37b form the variable capacitor 17Ga. A capacitance Cg is added to the line SR by the movable capacitor electrode 33a, and the movable capacitor electrode 33a or a portion formed by the movable capacitor electrode 33a and the line SR may be sometimes referred to as "load capacitor". Further, portions formed by the spring electrodes 33b and 33b and the driving electrodes 35a and 35b respectively may be sometimes referred to as "parallel plate aetuator".

A space between the top surface of the line SR and the bottom surface of the movable capacitor electrode 33a has a predetermined gap GP1 in a free state and it has the capacitance Cg corresponding to the gap. The size of the gap GP1 is, for example, about 0.1 to 10 $\mu$m.

A dielectric dot 39 is provided on the surface of the line SR, hence to increase the capacitance Cg between the line SR and the movable capacitor electrode 33a and enlarge the frequency variable range of the variable capacitor 17Ga. The dielectric dot 39 serves to prevent from short-circuit when the movable capacitor electrode 33a is drawn to the side of the line SR.

Although it is not illustrated in the drawings, the whole filter including the line SR and the variable electrode 33 in the upper surface of the substrate 31, is covered with the packaging material, hence to seal the whole filter.

Thus constituted filter 1G can be soldered to the surface of the print substrate, not illustrated, using the pads 38a to 38d, which enables the surface mounting.

By applying a control voltage Vb to the driving electrodes 35a and 35b through the pads 38a to 38d, there occurs an electrostatic attraction between the driving electrodes 35a and 35b and the spring electrodes 33b and 33b. According to the size of the control voltage Vb, namely, the size of the electrostatic attraction, the spring electrodes 33b and 33b are deflected, to change the size of the gap GP1. According to a change in the size of the gap GP1, the capacitance Cg between the top surface of the line SR and the movable capacitor electrode 33a varies. According to this, the electrical propagation length L of the line (resonance line) SR varies. By adjusting the control voltage Vb, the electrical propagation length L of each line SR, namely, the resonance wavelength $\lambda$ can be adjusted.

In the filter 1G, a microstrip transmission line is formed by the ground layer 31d inside the substrate 31 and the line (signal line) SR formed on the top surface. In the microstrip transmission line, the ground layer is not formed on the surface of the substrate with the line SR formed, a wide free area is provided on the both sides of the line SR. Therefore, the driving electrodes 35a and 35b can be comparatively freely arranged in the free area.

According to this, the area for the driving electrodes 35a and 35b can be gained enough and the control voltage Vb for driving the variable electrode 33 can be lowered.

Further, by gaining the area for the driving electrodes 35a and 35b fully, Self-Actuation phenomenon by the high frequency signal can be restrained. The reason is that since the electrostatic attraction can be increased by enlarging the area for the driving electrodes 35a and 35b, the spring constants of the spring electrodes 33b and 33b can be enlarged, which stabilizes the displacement operation of the variable electrode 33.

Further, the area for the driving electrodes 35a and 35b can be enlarged much more than the area of the movable capacitor electrode 33a, which makes it possible to ignore the Coulomb force between the movable capacitor electrode 33a and the line SR caused by the high frequency signal supplied there. Therefore, this also stabilizes the displacement operation of the variable electrode 33 and can restrain the Self-Actuation phenomenon.

As mentioned above, the structure of the filter 1G illustrated in Figs. 16 and 17 is advantageous for restraint of the Self-Actuation phenomenon of the parallel plate variable capacitor 17Ga.

[Description of Manufacturing Process of Filter]

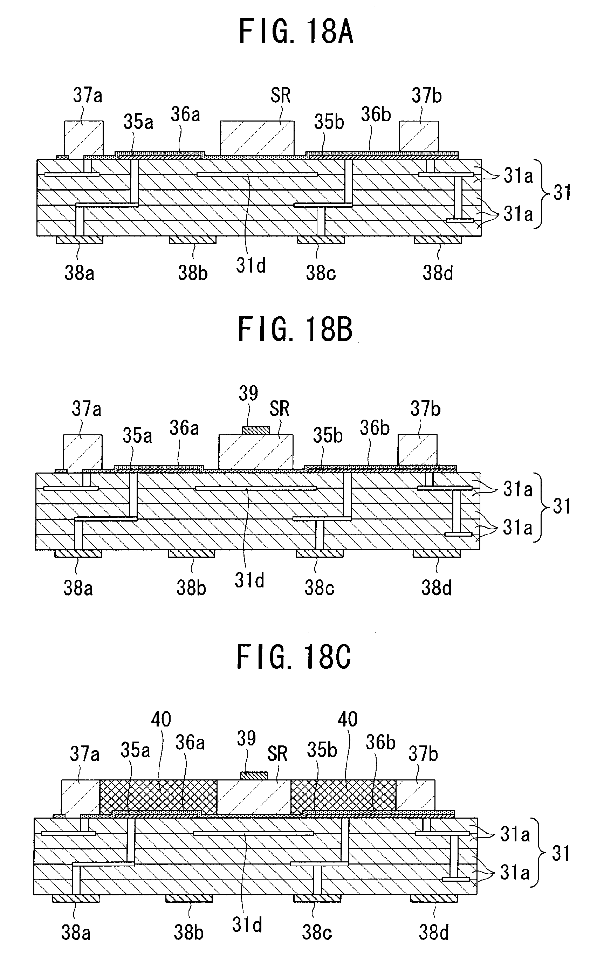

Next, the process of manufacturing the filter 1G will be described with reference to Figs. 18A to 20B. The following description is to illustrate one schematic example of the manufacturing process of the filter 1G and there are some portions which do not agree with the structure of the filter 1 G illustrated in Fig. 17.

At first, a wiring substrate wafer having a plurality of filter module formation regions is manufactured. The wiring substrate wafer is a wafer having a multi-layered wiring structure including insulating layers, wiring patterns, and vias. The wiring substrate wafer has a surface roughness Rz not greater than, for example, 0.2 urn on the side of forming the filter 1G.

In manufacturing the wiring substrate wafer, at first openings for vias are formed in each ceramic substrate that is provided as a green sheet. The openings are filled with the conductive paste and a wiring pattern is printed on the surface of the ceramic substrate by using the conductive paste. A predetermined number of the ceramic substrates obtained through the above processes are piled as a laminated body and the laminated body is pressed in its thickness direction under heating. Thereafter, a predetermined thermal process is conducted to sinter the laminated body integrally, hence to obtain prewiring substrate wafer. The wiring patterns and vias are formed through the integral sintering.

The position of the vias exposed on the surface of the wiring substrate wafer may fluctuate from the design positions due to the shrinking phenomenon of ceramic material at sintering. When the upper structure of the wiring substrate wafer is formed through the photolithography process, the positions of the vias exposed on the substrate surface should be controlled in the abovementioned manufacturing process of the wiring substrate wafer. For example, the deviation amount of the via positions from the design position is controlled to a level of $\pm 50\ \mu$m and less.

Next, lapping is performed on the both surfaces of the pre-wiring substrate wafer. As a method of lapping, for example, mechanical lapping with a predetermined lapping agent (chemical liquid) can be adopted. This lapping processing reduces warpage and undulation in the pre-wiring substrate wafer. The lapping processing should preferably decrease warpage to a level not greater than 40 $\mu$m and decrease undulation to almost nothing.

Further, the pre-wiring substrate wafer may sometimes need smoothing processing on the surface having the above mentioned passive devices and resonance lines formed.

Namely, since the surface of the pre-wiring substrate wafer has uneven portions which are apparently due to the grain size of material ceramic and the grinding action by the lapping agent, even the optimum selection of ceramic material and the optimum lapping method cannot improve the surface roughness Rz with much lower than 5 $\mu$m on the surface of the pre-wiring substrate wafer. It is difficult to appropriately form small-sized passives device on this uneven surface.

In order to avoid the above problem, predetermined smoothing processing is performed after the above-mentioned lapping processing in manufacturing the wiring substrate wafer. In the smoothing processing, at first, a thin insulating film is formed on the uneven surface of the insulating layer on the surface of the lapped pre-wiring substrate wafer. The insulating film is formed by applying thin coating of insulation liquid and sintering the above on the surface of the pre-wiring substrate wafer. The insulation coating liquid may be provided by SOG (spin-on-glass). The thickness of the applied insulation coating liquid is, for example, 1 $\mu$m and less. By forming the thin insulating film in such a way, surface depression on the pre-wiring substrate wafer can be decreased.

Thereafter, the process of forming the insulating film is repeated for a predetermined number until the projections on the ceramic surface of the pre-wiring substrate wafer are buried in the insulating film formed by piling a plurality of the insulating films. Thus, in the prewiring substrate wafer, the surface roughness RZ on its whole surface having the passive devices and resonance lines formed can be reduced to 0.5 $\mu$m and less. The wiring substrate wafer is obtained by performing this smoothing processing after the above-mentioned lapping processing.

In thus manufactured wiring substrate wafer, in a level of wafer, a plurality of the passive devices and the resonance lines are formed in every formation region of a filter module, according to the batch production method, through the processes of the following (1) to (7). Then, the wiring substrate wafer is divided into formation regions, to obtain a filter module. The processes illustrated in (1) to (7) are taken as one example and besides, various kinds of semiconductor manufacturing processes and MEMS processes can be properly used.

(1) As illustrated in Fig. 18A, a metal film layer is formed on the upper surface of the substrate (wiring substrate wafer) 31 and patterned, to form the driving electrodes 35a and 35b. An insulating film is formed on the driving electrodes 35a and 35b, to form the dielectric films 36a, 36b. A metal film layer is formed on the lower surface of the substrate 31 and etched, to form the pads 38a to 38d. Alternatively, the pads 38a to 38d may be formed by plating. Further, the anchor units 37a and 37b and the line SR are formed on the upper surface of the substrate 31 by using the Au plating technique.

(2) As illustrated in Fig. 18B, the dielectric dot 39 is formed on the line SR formed of Au.

(3) As illustrated in Fig. 18C, a sacrifice layer 40 is formed with the same thickness as the line SR. The sacrifice layer 40 is formed of easily eliminable resist material which can be selectively etched.

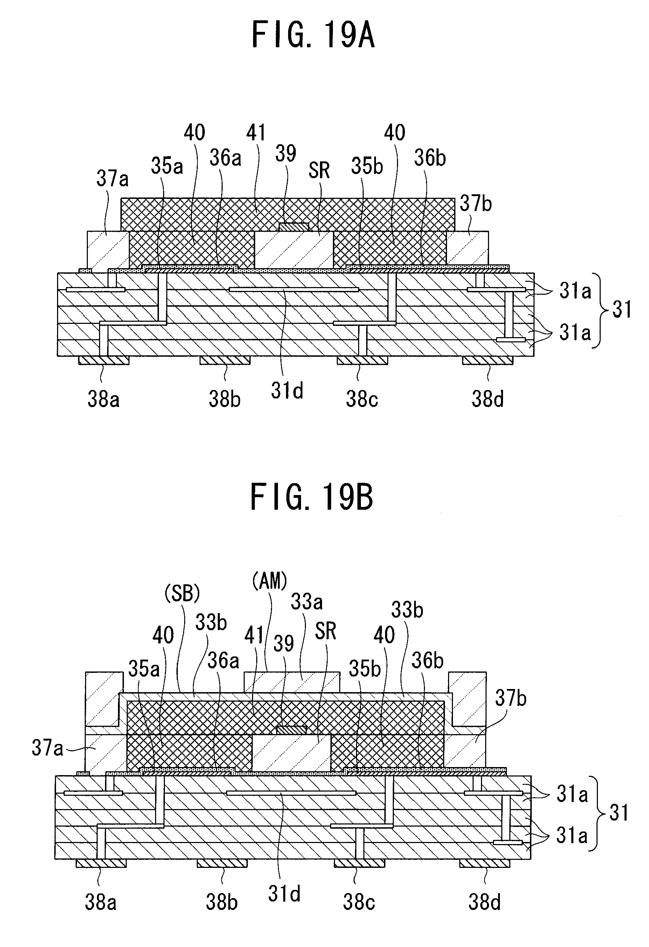

(4) As illustrated in Fig. 19A, a second sacrifice layer 41 for the variable electrode 33 is formed on the sacrifice layer 40. The thickness of the second sacrifice layer 41 defines the size (distance) of the gap GP1 between the variable electrode 33 and the line SR. Further, the size (distance) of a gap GP2 between the variable electrode 33 and the driving electrodes 35a and 35b is defined by the sum of the thickness of the sacrifice layer 40 and the second sacrifice layer 41.

In the case of the parallel plate actuator like the variable capacitor 17Ga of this embodiment, the displacement amount of the limit free from the Pull-In phenomenon is about one third of the distance between electrodes. In order to fully take a wide variable range of the variable capacitor 17Ga, the movable capacitor electrode 33a has to get closed to the line SR. Therefore, the gaps GP1 and GP2 between the electrodes are different between the parallel-plate actuator and the load capacitor. The thickness of the sacrifice layer in the parallel-plate actuator is supposed to be three times larger or more than the thickness of the sacrifice layer of the load capacitor. In order to make the surface of the variable electrode 33 flat, the sacrifice layer should be flat as a base. To meet the above needs, a method of forming the two sacrifice layers: the sacrifice layer 40 and the second sacrifice layer 41 (referred to as "two sacrifice layer method"), is effective.

(5) As illustrated in Fig. 19B, a sheet spring layer SB is formed on the second sacrifice layer 41 and a thick metal film portion AM is formed in the middle portion of the sheet spring layer SB, according to the plating technique. A pattern for the variable electrode 33 having the spring electrodes 33b and 33b and the movable capacitor electrode 33a is formed by using the milling technology.

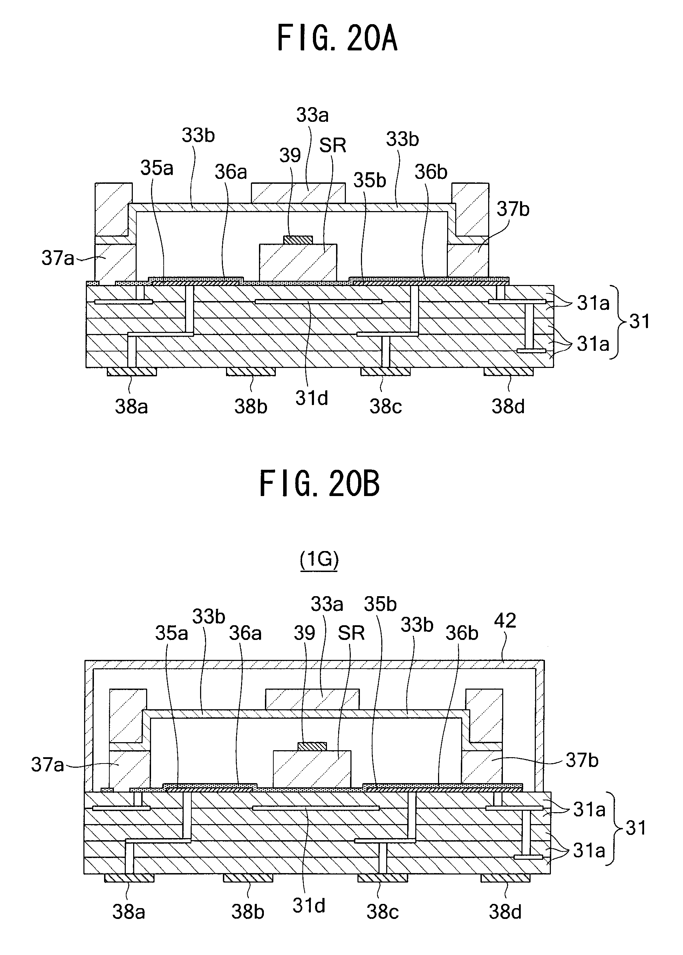

(6) As illustrated in Fig. 20A, the sacrifice layer 40 and the second sacrifice layer 41 are eliminated, to release the device.

(7) As illustrated in Fig. 20B, a packaging material 42 is used to seal the wafer at the wafer level. Then, each filter module (filter 1G) is cut out from the substrate 31.

In the processes as illustrated above, formation and sealing of the device (filter 1G) are performed all at the wafer level, and therefore, the invention, superior in mass productivity and cost performance, can improve the production efficiency.

Further, since the wiring substrate wafer 31 has the vias 31b for conduction and the pads 38a to 38d for installation, the completed filter module (filter 1G) can be directly used for installation in a print substrate such as a mother board without installation to another package, which is advantageous in practical use.

In the above-mentioned embodiment, n in the formula (1) is defined as one; however, n may be odd number other than one, like 3, 5, 7, ....

[Communication Module]

The filters 1 to 1K of the embodiment can be formed as a communication module TM.

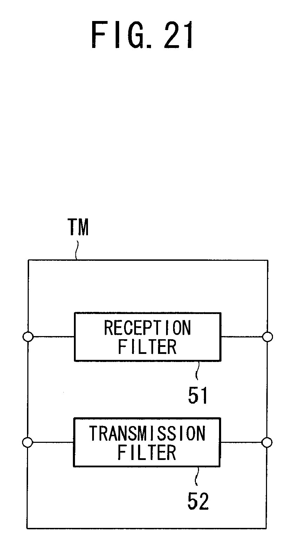

In Fig. 21, the communication module TM is formed by a transmission filter 51 and a reception filter 52. The frequency fixed filters illustrated in the first to the third embodiments or the frequency variable filters illustrated in the fourth and the fifth embodiments can be used as the transmission filter 51 and the reception filter 52. Alternatively, the frequency fixed filter and the frequency variable filter may be mixed.

In the case of the frequency fixed filter, a filter suitable for each communication is selected from a plurality of the filters. The respective filters can be kept as a band pass filter having a proper central pass frequency $f_0$ (central pass wavelength $\lambda_0$), attenuation frequencies $f_L$ and $f_H$ (wavelengths $\lambda_L$ and $\lambda_H$ at attenuation peak), and a pass loss characteristic, by properly adjusting the electrical propagation length L of the resonance line KS.

In the case of the frequency variable type, each filter is provided with the control voltage Vb and the central pass frequency $f_0$, the attenuation frequencies $f_L$ and $f_H$, and the pass loss characteristic are decided according to each communication. In this case, it is possible to decrease the number of the filters in the transmission filter 52 or the reception filter 53, hence to downsize a communication device TS. By decreasing the number of the filters, it is possible to simplify the circuit, to decrease the circuit loss and the circuit noise, hence to improve the performance of the communication module TM.

The communication module TM can be formed in various structures other than the structure illustrated in Fig. 21.

[Communication Device]

The filters 1 to 1K of the embodiment can be applied to various communication devices including a mobile communication device such as a mobile phone and a portable terminal, a Base-station (base station) device, and a fixed communication device.

Here, one example of the communication device with the filters 1 to 1K applied will be described.

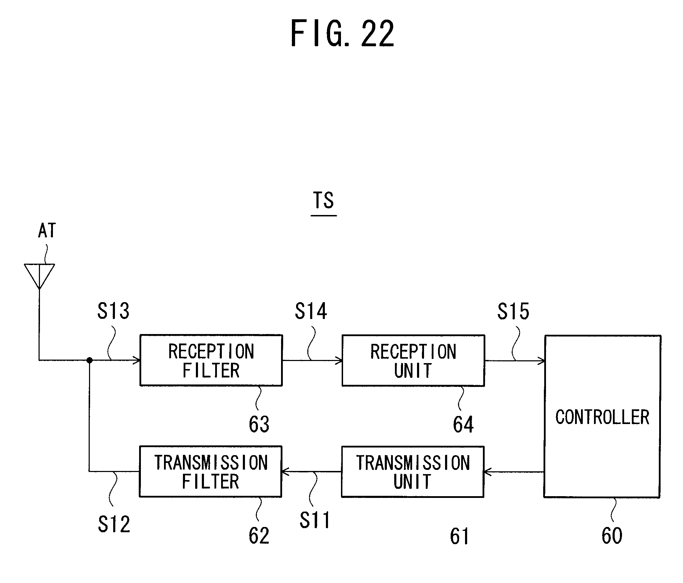

In Fig. 22, the communication device TS includes a controller 60, a transmission unit 61, a transmission filter 62, a reception filter 63, a reception unit 64, and an antenna AT.

The controller 60 controls the whole communication device TS while performing predetermined digital and analog processing on the communication device TS and working as a human interface with a user.

The transmission unit 61 supplies a high frequency signal S11 after modulation is performed on the signal. The high frequency signal S11 includes signals of various frequency bands.

The transmission filter 62 filters the high frequency signal S11 supplied from the transmission unit 61 so that only the frequency band specified by the controller 60 may pass through the filter. A filtered high frequency signal S12 is supplied from the transmission filter 62. The transmission filter 62 uses one of the filters 1 to 1K having been described in the first to the fifth embodiments or their variations.

The reception filter 63 filters a high frequency signal S13 received from the antenna AT so that only the frequency band specified by the controller 60 may pass through the filter. A filtered high frequency signal S14 is supplied from the reception filter 63. The reception filter 63 uses one of the filters 1 to 1K having been described in the first to the fifth embodiments or their variations.

The reception unit 64 amplifies and demodulates the high frequency signal S14 supplied from the reception filter 63 and supplies an obtained receiving signal S 15 to the controller 60.

The antenna AT radiates the high frequency signal S12 supplied from the transmission filter 62 in the air as radio wave and receives the radio wave transmitted from a wireless station not illustrated.

When the transmission filter 62 or the reception filter 63 is of the frequency fixed type as illustrated in the first to the third embodiments, a filter suitable for each communication is selected from a plurality of these filters. By properly adjusting the electrical propagation length L of the resonance line KS, the respective filters can be kept as the band pass filters each having the appropriate central pass frequency $f_0$ (central pass wavelength $\lambda_0$), attenuation frequencies $f_L$ and $f_H$ (wavelengths $\lambda_L$ and $\lambda_H$ at the attenuation peak), and pass loss characteristic.

While, when the transmission filter 62 or the reception filter 63 is of the frequency variable type as illustrated in the fourth and the fifth embodiments, the control voltage Vb is given there according to a command from the controller 60 and the central pass frequency $f_0$, the attenuation frequencies $f_L$ and $f_H$, and the pass loss characteristic are determined according to each communication. In this case, the number of the filters in the transmission filter 62 or in the reception filter 63 can be decreased, hence to downsize the communication device TS. By decreasing the number of the filters, the circuit can be simplified, the circuit loss and the circuit noise can be decreased, and the performance of the communication device TS can be improved.

In the structure of the above-mentioned communication device TS, the filter may be provided as a circuit element other than the transmission filter 62 and the reception filter 63, for example, a band pass filter for intermediate frequencies. Further, a switch for switching the antenna AT, and the transmission filter 62 or the reception filter 63 at the transmission and reception time is provided according to the necessity. The above-mentioned communication module TM may be used as the transmission filter 62 and the reception filter 63.

Further, the communication device TS is provided with a low noise amplifier, a power amplifier, a duplexer, an AD convertor, a DA convertor, a frequency synthesizer, an ASIC (Application Specific Integrated Circuit), a DSP (Digital Signal Processor), and a power unit, according to the necessity.

When the communication device TS is a mobile phone, it is formed in the structure conforming to the communication method, and the transmission filter 62 or the reception filter 63 selects the frequency band according to the communication method. For example, in the case of GSM (Global System for Mobile Communications) communication method, it is set to conform to 850 MHz band, 950 MHz band, 1.8 GHz band, and 1.9 GHz band. The filter of the embodiment is applicable to the communication device TS conforming to 2GHz band and more, for example, 6 GHz band and 10 GHz band.

In addition to the above-mentioned various embodiments and variation examples, the input terminal 11, the resonance line KS such as the first resonance line 12a and the second resonance line 12b, the resonance line pair ZT, the input point 13, the coupling unit 14, the output terminal 15, the input signal line 16, the output signal line 16, the variable capacitor 17, the filters 1 to 1K, the communication module TM, and the whole or each unit of the communication device TS may be variously modified in the structure, shape, size, material, forming method, manufacturing method, arrangement, number of units, and position.

All examples and conditional language recited herein are intended for pedagogical purposes to aid the reader in understanding the principles of the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present inventions have been described in detail, it should be understood that the various changes, substitutions, and alterations could be made hereto without departing from the scope of the claims.

**Claims**

1. A filter comprising:

   a first resonance line and a second resonance line which extend from an input point where a high frequency signal is input, wherein
   an electrical propagation length $L_1$ of the first resonance line is set at $L_1 = [\lambda_1/4] \times n$ and an electrical propagation length $L_2$ of the second resonance line is set at $L_2 = [\lambda_2/4] \times n$,
   wherein $\lambda_1$ and $\lambda_2$ are wavelengths of specified high frequency signals and n is positive odd number.

2. The filter according to claim 1, wherein
   the wavelength $\lambda_1$ and the wavelength $\lambda_2$ are different from each other, and
   intermediate wavelength $\lambda_0$ between the wavelength $\lambda_1$ and the wavelength $\lambda_2$ is a central pass wavelength and the wavelength $\lambda_1$ and the wavelength $\lambda_2$ are attenuation wavelengths.

3. The filter according to claim 1, wherein
   at least one of the first resonance line and the second resonance line is provided with a variable capacity element and at least one of the electrical propagation length $L_1$ and the electrical propagation length $L_2$ is variable by the variable capacity element.

4. The filter according to claim 3, further comprising:

   a first movable capacitor electrode which is arranged above the first resonance line with a first gap interposed therebetween;
a second movable capacitor electrode which is arranged above the second resonance line with a second gap interposed therebetween;
a first driving electrode which displaces the first movable capacitor electrode with respect to the first driving electrode; and
a second driving electrode which displaces the second movable capacitor electrode with respect to the second driving electrode.

5. The filter according to claim 3, wherein the first resonance line and the second resonance line extend from the input point in opposite directions.

6. The filter according to claim 5, wherein the first resonance line and the second resonance line form a shape of a single straight line.

7. The filter according to claim 5, wherein the first resonance line and the second resonance line are respectively formed in straight lines and the first resonance line and the second resonance line are inclined with respect to each other.

8. The filter according to claim 5, wherein the first resonance line and the second resonance line are respectively formed in an arc shape.

9. The filter according to claim 3, wherein distal ends of the first resonance line and the second resonance line are electrically open.

10. The filter according to any of claims 3 to 9, wherein a plurality of resonance line pairs are provided, including the first resonance line and the second resonance line, wherein the resonance line pairs are mutually coupled by a coupling unit.

11. The filter according to claim 10, wherein the coupling unit is $\pi$-type or T-type.

12. The filter according to claim 10 or 11, wherein the coupling unit includes at least one variable capacity element or one variable inductance element.

13. The filter according to claim 4, wherein the first resonance line, the second resonance line, the first movable capacitor electrode, the second movable capacitor electrode, the first driving electrode, and the second driving electrode are formed on a common substrate.

14. The filter according to claim 14, wherein the substrate is a low temperature co-fired ceramic substrate including multi-layered internal wiring.

15. A communication module including a filter, the filter comprising:

a first resonance line and a second resonance line which extend from an input point where a high frequency signal is input, wherein an electrical propagation length $L_1$ of the first resonance line is set at $L_1 = [\lambda_1/4] \times n$ and an electrical propagation length $L_2$ of the second resonance line is set at $L_2 = [\lambda_2/4] \times n$,
wherein $\lambda_1$ and $\lambda_2$ are wavelengths of specified high frequency signals and n is positive odd number.

16. A filtering method, comprising:

inputting a high frequency signal including a wavelength component of a specified wavelength $\lambda_0$ in an input terminal of a signal line; and
supplying the signal from an output terminal of the signal line after filtering the signal so that the waveform component of the wavelength $\lambda_0$ is allowed to pass, by performing parallel resonance on the wavelength component of the wavelength $\lambda_0$ by a first resonance line and a second resonance line when the first resonance line and the second resonance line respectively extend from one contact on the signal line,
wherein n is a positive odd number, and electrical propagation length $L_1$ of the first resonance line is set at $L_1 = [(\lambda_0 + \Delta\lambda)/4] \times n$ and electrical propagation length $L_2$ of the second resonance line is set at $L_2 = [(\lambda_0 - \Delta\lambda)/4] \times n$.

17. The filtering method according to claim 16, wherein at least one of the electrical propagation length $L_1$ and the electrical propagation length $L_2$ is varied by a variable capacity element provided in at least one of the first resonance line and the second resonance line.

# FIG. 1

# FIG. 2A

L=λ/4

KT

KS1 (12a, 12b)

S1    13

GND

KT

C

L

λ

S1    13

# FIG. 2B

L=λ/2

KT

KS2 (ZT)

S1    13

GND

KH

C        L

λ

S1    13

# FIG. 3

# FIG. 4

# FIG. 5A

## 1B

KT

ZTB

12Ba

13B

11B — 15B

12Bb

KT

# FIG. 5B

## 1C

12Ca

ZTC

KT

13C

11C — 15C

KT

12Cb

# FIG. 5C

## 1D

KT

ZTD

12Da

13D

11D — 15D

KT

12Db

EP 2 230 714 A1

# FIG. 6

FIG. 7

# FIG. 8A

14F1

14a

# FIG. 8B

14F2

141

142

143

# FIG. 8C

14F3

145    146

147

# FIG. 9A

14F4

# FIG. 9B

14F5

# FIG. 9C

14F6

# FIG. 10A

14F7

L31
C31
L32  C32  L33  C33

# FIG. 10B

14F8

L41
C41
C42  C43

# FIG. 10C

14F9

14e
L51  C51  L52  C52

# FIG. 11A

14F10

L60    L61

C61    C62

L62    C63    L63    C64

# FIG. 11B

14F11

L61

C61    C62

L62    C63    L63    C64

# FIG. 11C

14F12

L72

L71

C71

L73    C72    L74    C73

# FIG. 12A

14F13

C91           C92

L91           L92

L93     C93

# FIG. 12B

14F14

14f           14g

14h

# FIG. 13

1G

KT                    KT

ZTG1              17Gc ⌐            ZTG2

17Ga ⌐                              12Gc

17Ge

12Ga

11G        15G

INPUT        OUTPUT

13Ga        13Gb

17Gb      12Gb    14G    17Gd      12Gd

KT                    KT

FIG. 14A

FIG. 14B

FIG. 14C

# FIG. 15

<u>1K</u>

$L_{10}=\lambda_L/4$  KT  12Ka  17Ka  13Ka  ZTK1

$\lambda/2$ RESONANCE LINE

11K  16Ka  13Ka

$L_{11}=\lambda_H/4$  17Kb  12Kb  KT

17Ke  14K

ZTK2  KT  12Kc  17Kc  $L_{12}=\lambda_L/4$

13Kb  16Kb  15K

$L_{13}=\lambda_H/4$  17Kd  12Kd  KT

EP 2 230 714 A1

# FIG. 16

# FIG. 17

# FIG. 18A

# FIG. 18B

# FIG. 18C

# FIG. 19A

# FIG. 19B

# FIG. 20A

# FIG. 20B

(1G)

# FIG. 21

TM

RECEPTION
FILTER

51

TRANSMISSION
FILTER

52

# FIG. 22

TS

# FIG. 23

# FIG. 24

Europäisches
Patentamt
European
Patent Office
Office européen
des brevets

**EUROPEAN SEARCH REPORT**

Application Number

EP 10 15 4547

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 3 875 538 A (MINET ROGER P ET AL) 1 April 1975 (1975-04-01) | 1,2,5-7, 9-12,15, 16 | INV. H01P1/203 |
| Y | * abstract * * column 1, line 60 - column 2, line 15 * | 3,4,8, 13,14,17 | ADD. H03H7/01 |
| Y | EP 1 986 319 A2 (FUJITSU LTD [JP]) 29 October 2008 (2008-10-29) * abstract * * figures 1-4 * | 3,4,13, 14,17 | |
| Y | CH 333 076 A (STANDARD TELEPHONE & RADIO SA [CH]) 30 September 1958 (1958-09-30) * page 2, lines 23-68 * | 8 | |
| X | EP 0 537 798 A1 (MATSUSHITA ELECTRIC IND CO LTD [JP]) 21 April 1993 (1993-04-21) * column 6, line 51 - column 7, line 39 * | 1-17 | |
| X | US 4 074 214 A (AICHHOLZER RONALD ALBERT) 14 February 1978 (1978-02-14) * column 2, line 37 - column 4, line 19 * | 1,3-17 | TECHNICAL FIELDS SEARCHED (IPC) H01P |

The present search report has been drawn up for all claims

| Place of search | Date of completion of the search | Examiner |
|---|---|---|
| Munich | 25 May 2010 | van Norel, Jan |

EPO FORM 1503 03.82 (P04C01)

## ANNEX TO THE EUROPEAN SEARCH REPORT
## ON EUROPEAN PATENT APPLICATION NO.

EP 10 15 4547

This annex lists the patent family members relating to the patent documents cited in the above-mentioned European search report.
The members are as contained in the European Patent Office EDP file on
The European Patent Office is in no way liable for these particulars which are merely given for the purpose of information.

25-05-2010

| Patent document cited in search report | | Publication date | Patent family member(s) | | Publication date |
|---|---|---|---|---|---|
| US 3875538 | A | 01-04-1975 | DE | 2408634 A1 | 21-08-1975 |
| | | | FR | 2220929 A1 | 04-10-1974 |
| | | | GB | 1421311 A | 14-01-1976 |
| | | | GB | 1426702 A | 03-03-1976 |
| | | | US | 3857114 A | 24-12-1974 |
| EP 1986319 | A2 | 29-10-2008 | CN | 101295809 A | 29-10-2008 |
| | | | EP | 2101412 A1 | 16-09-2009 |
| | | | JP | 2008278147 A | 13-11-2008 |
| | | | KR | 20080096441 A | 30-10-2008 |
| | | | US | 2008266029 A1 | 30-10-2008 |
| CH 333076 | A | 30-09-1958 | NONE | | |
| EP 0537798 | A1 | 21-04-1993 | NONE | | |
| US 4074214 | A | 14-02-1978 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008278147 A

**Non-patent literature cited in the description**

- **D. Peroulis et al.** Tunable Lumped Components with Applications to Reconfigurable MEMS Filters. *IEEE MTT-S Digest,* 2001, 341-344
- **E. Foum et al.** MEMS Switchable Interdigital Coplanar Filter. *IEEE Trans. Microwave Theory Tech.,* January 2003, vol. 51 (1), 320-324
- **A. A. Tamijani et al.** Miniature and Tunable Filters Using MEMS Capacitors. *IEEE Trans. Microwave Theory Tech.,* July 2003, vol. 51 (7), 1878-1885